# EUROPÄISCHE PATENTSCHRIFT

(11) **EP 4 338 202 B1**
(45) Veröffentlichungstag und Bekanntmachung des Hinweises auf die Patenterteilung: **09.09.2026**
(21) Anmeldenummer: 22735820.7
(22) Anmeldetag: 13.06.2022
(51) Int. Cl.: H10W 72/00, H10W 72/90, H10W 72/50, H10W 90/00, H10W 70/60, H10W 70/65, H10W 72/59

(54) **HALBLEITERANORDNUNG MIT EINEM HALBLEITERELEMENT, EINEM SUBSTRAT UND EINEM VERBINDUNGSMITTEL UND VERFAHREN ZU DEREN HERSTELLUNG**
SEMICONDUCTOR DEVICE COMPRISING A SEMICONDUCTOR ELEMENT, A SUBSTRATE AND A CONNECTING MEANS, AND METHOD FOR THE PRODUCTION THEREOF
DISPOSITIF SEMI-CONDUCTEUR COMPRENANT UN ÉLÉMENT SEMI-CONDUCTEUR, UN SUBSTRAT ET UN MOYEN D'INTERCONNEXION ET SON PROCÉDÉ DE FABRICATION

(30) Priorität: 13.07.2021 EP 21185247
(43) Veröffentlichungstag der Anmeldung: 20.03.2024
(73) Patentinhaber: Siemens Aktiengesellschaft, 80333 München (DE)
(72) Erfinder: KÜRTEN, Bernd, 90587 Obermichelbach (DE); ZEYSS, Felix, 91052 Erlangen (DE)
(74) Vertreter: Siemens Patent Attorneys
(86) Internationale Anmeldenummer: PCT/EP2022/065945
(87) Internationale Veröffentlichungsnummer: WO 2023/285046

(56) Entgegenhaltungen:
- DE-A1- 102019 114 520
- DE-A1- 102019 200 634
- DE-T5- 112019 000 660
- JP-U- S52 152 678
- US-A1- 2007 182 026

## Beschreibung

Die Erfindung betrifft eine Halbleiteranordnung mit einem Halbleiterelement, einem Substrat und Bondverbindungsmitteln.

Ferner betrifft die Erfindung ein Halbleitermodul mit mindestens einer derartigen Halbleiteranordnung.

Darüber hinaus betrifft die Erfindung einen Stromrichter mit mindestens einem derartigen Halbleitermodul.

Überdies betrifft die Erfindung ein Verfahren zur Herstellung einer Halbleiteranordnung mit einem Halbleiterelement, einem Substrat und Bondverbindungsmitteln.

Eine derartiges Halbleitermodul kommt in der Regel in einem Stromrichter zum Einsatz. Unter einem Stromrichter ist beispielsweise ein Gleichrichter, ein Wechselrichter, ein Umrichter oder ein Gleichspannungswandler zu verstehen. Die im Halbleitermodul zum Einsatz kommenden Halbleiterelemente sind unter anderem Transistoren, Triacs, Thyristoren oder Dioden. Transistoren sind beispielsweise als Insulated-Gate-BipolarTransistoren (IGBTs), Feldeffekttransistoren oder Bipolartransistoren ausgeführt. Die Halbleiterelemente einer Halbleiteranordnung sind üblicherweise über Bondverbindungsmittel auf einem Substrat kontaktiert. Derartige Bondverbindungsmittel können unter anderem als Bonddrähte und/oder Bondbänder ausgeführt sein. Insbesondere Leistungskontakte eines Halbleiterelements, unter anderem ein Emitter-Kontakt eines IGBTs, sind üblicherweise mit einer Mehrzahl von Bondverbindungsmitteln auf dem Substrat kontaktiert.

Die Patentschrift DE 11 2004 000 727 B4 beschreibt eine elektronische Baugruppe umfassend eine elektronische Vorrichtung mit einer leitenden oberen Oberfläche, einen zu der elektronischen Vorrichtung externen leitenden Anschluss undein leitendes Band, das an einen ersten Abschnitt der leitenden oberen Oberfläche ultraschallgebondet ist und an den leitenden Anschluss gebondet ist, wobei das leitende Band eine erste Schicht umfasst, die die leitende obere Oberfläche kontaktiert, und eine zweite Schicht, die über der ersten Schicht liegt, wobei die erste Schicht aus Aluminium und die zweite Schicht aus Kupfer ist.

In der Regel ist es vorteilhaft, die Halbleiterelemente der Halbleiteranordnung in einem Halbleitermodul möglichst weit voneinander entfernt zu platzieren, um beispielsweise eine optimale Entwärmung durch Wärmespreizung zu erreichen. Um die Maße des Halbleitermoduls dennoch möglichst gering zu halten, ist zusätzlicher Bauraum für die Verdrahtung, beispielsweise zur Kontaktierung von Steuerkontakten, unter anderem ein Gate-Kontakt eines IGBTs, zu minimieren. Insbesondere wenn Halbleiterelemente dicht an einem Modulrand platziert werden, wo sich üblicherweise Anschlusspins eines Gehäuses befinden, welche ebenfalls über Bondverbindungsmittel modulintern verschalten werden, ergeben sich Schwierigkeiten bei der Verdrahtung innerhalb Halbleitermodul. Insbesondere bei den Steuerkontakten wirken sich lange Bonddrähte und damit verbundene hohe Bond-Induktivitäten unter anderem negativ auf die elektrische Performance der Schaltung aus.

Die Offenlegungsschrift DE 11 2019 000 660 T5 beschreibt Substrate, die eine Hauptoberfläche besitzen, mehrere Leitermuster, die auf der Hauptoberfläche vorgesehen sind, mehrere Schaltelemente, die auf den mehreren Leitermustern angeordnet sind, um Kollektor-Elektroden zu verbinden, und ein einzelnes oder mehrere Verdrahtungselemente, die Emitter-Elektroden der Verdrahtungselemente, die auf verschiedenen Leitermustern angeordnet und zwischen den mehreren Schaltelementen parallelgeschaltet sind, direkt verbinden.

Vor diesem Hintergrund liegt der Erfindung die Aufgabe zugrunde, eine Halbleiteranordnung anzugeben, welche, im Vergleich zum Stand der Technik, eine verbesserte Verdrahtung aufweist.

Die Aufgabe wird erfindungsgemäß gelöst durch eine Halbleiteranordnung mit einem Halbleiterelement, einem Substrat und Bondverbindungsmitteln, wobei das Halbleiterelement, insbesondere stoffschlüssig, mit dem Substrat verbunden ist, wobei das Halbleiterelement auf einer dem Substrat abgewandten Seite zumindest eine Kontaktfläche aufweist, wobei zumindest eine Kontaktfläche des Halbleiterelements über zumindest ein erstes Bondverbindungsmittel mit dem Substrat verbunden ist, wobei das zumindest eine erste Bondverbindungsmittel auf der Kontaktfläche jeweils zumindest einen ersten Steppkontakt ausbildet, welcher zwischen einem ersten Loop und einem zweiten Loop des jeweiligen ersten Bondverbindungsmittels angeordnet ist, wobei der erste Loop ein erstes Maximum und der zweite Loop ein zweites Maximum aufweist, wobei ein erster Quer-Loop eines zweiten Bondverbindungsmittels oberhalb des ersten Steppkontakts und, parallel zur Kontaktfläche verlaufend betrachtet, zwischen dem ersten Maximum des ersten Loops und dem zweiten Maximum des zweiten Loops verlaufend angeordnet ist.

Ferner wird die Aufgabe erfindungsgemäß gelöst durch ein Halbleitermodul mit mindestens einer derartigen Halbleiteranordnung.

Überdies wird die Aufgabe erfindungsgemäß gelöst durch einen Stromrichter mit mindestens einem derartigen Halbleitermodul.

Darüber hinaus wird die Aufgabe erfindungsgemäß gelöst durch ein Verfahren zur Herstellung einer Halbleiteranordnung mit einem Halbleiterelement, einem Substrat und Bondverbindungsmitteln, wobei das Halbleiterelement, insbesondere stoffschlüssig, mit dem Substrat verbunden ist, wobei das Halbleiterelement auf einer dem Substrat abgewandten Seite zumindest eine Kontaktfläche aufweist, wobei zumindest eine Kontaktfläche des Halbleiterelements über zumindest ein erstes Bondverbindungsmittel mit dem Substrat verbunden wird, wobei das zumindest eine erste Bondverbindungsmittel auf der Kontaktfläche jeweils zumindest einen ersten Steppkontakt ausbildet, welcher zwischen einem ersten Loop und einem zweiten Loop des jeweiligen ersten Bondverbindungsmittels angeordnet ist, wobei der erste Loop ein erstes Maximum und der zweite Loop ein zweites Maximum aufweist, wobei in einem weiteren Schritt ein erster Quer-Loop eines zweiten Bondverbindungsmittels oberhalb des ersten Steppkontakts und, parallel zur Kontaktfläche verlaufend betrachtet, zwischen dem ersten Maximum des ersten Loops und dem zweiten Maximum des zweiten Loops verlaufend angeordnet wird.

Die in Bezug auf die Halbleiteranordnung nachstehend angeführten Vorteile und bevorzugten Ausgestaltungen lassen sich sinngemäß auf das Halbleitermodul, den Stromrichter und das Verfahren übertragen.

Der Erfindung liegt die Überlegung zugrunde, eine kompakte Verdrahtung einer Halbleiteranordnung anzugeben, um eine optimale Entwärmung und elektrische Performance zu erreichen. In einer derartigen Halbleiteranordnung ist zumindest ein Halbleiterelement, insbesondere stoffschlüssig, mit einem Substrat verbunden, wobei das Halbleiterelement beispielsweise als ein Insulated-Gate-Bipolar-Transistor (IGBT) ausgeführt ist, wobei eine derartige stoffschlüssige Verbindung z.B. über eine Löt- oder Sinterverbindung herstellbar ist. Zumindest eine auf einer dem Substrat abgewandten Seite des Halbleiterelements angeordneten Kontaktfläche ist über zumindest ein erstes Bondverbindungsmittel mit dem Substrat verbunden. Das zumindest eine erste Bondverbindungsmittel kann unter anderem als Bonddraht oder Bondband ausgeführt sein. Beispielsweise wird zumindest ein Dickdrahtbond, insbesondere aus Aluminium, mit einem im Wesentlichen kreisförmigen Querschnitt mit einem Durchmesser im Bereich von 100 µm bis 500 µm verwendet. Die Verbindung zur Kontaktfläche des Halbleiterelements wird mittels Durchschleifen des zumindest einen ersten Bondverbindungsmittels, insbesondere mittels Multi-Stitch Wedge-to-Wedge-Wirebonding, hergestellt. Durch das mehrfache Bonden, das auch "Stitchen" genannt wird, wird zumindest ein erster Steppkontakt ausbildet, welcher zwischen einem ersten Loop und einem zweiten Loop eines ersten Bondverbindungsmittels angeordnet ist. Üblicherweise werden derartige Steppkontakte auch als "Stitchbonds" bezeichnet und können z.B. als "Wedgebonds" ausgeführt sein. Der erste Loop weist ein erstes Maximum auf, während der zweite Loop ein zweites Maximum aufweist. Durch das "Stitchen" wird eine verbesserte Stromverteilung auf einem Halbleiterelement erreicht.

Ein zweites Bondverbindungsmittel, welches unter anderem als Bonddraht oder Bondband ausgeführt sein kann, wird zur weiteren Verdrahtung, beispielsweise zur Kontaktierung zumindest eines Steuerkontakts oder eines Hilfsemitters, herangezogen. Ein erster Quer-Loop des zweiten Bondverbindungsmittels wird oberhalb des ersten Steppkontakts und zwischen dem ersten Maximum des ersten Loops und dem zweiten Maximum des zweiten Loops verlaufend angeordnet. Durch einen derartigen Verlauf des zweiten Bondverbindungsmittels über das Halbleiterelement wird eine kürzere Bond-Induktivität erreicht, was sich unter anderem positiv auf die elektrische Performance der Schaltung auswirkt. Ferner wird Bauraum eingespart und es wird eine höhere Flexibilität bei der Verdrahtung aber auch bei der Platzierung des zumindest einen Halbleiterelements in der Halbleiteranordnung erreicht, was unter anderem zu einer optimalen Entwärmung, z.B. durch Wärmespreizung, führt.

Der erste Quer-Loop des zweiten Bondverbindungsmittels ist, insbesondere vollständig, unterhalb des ersten Maximums des ersten und/oder des zweiten Maximums des zweiten Loops verlaufend angeordnet. Der erste Quer-Loop des zweiten Bondverbindungsmittels ist unterhalb des ersten Maximums und/oder des zweiten Maximums angeordnet, wenn zumindest ein Teil der Querschnittsfläche des zweiten Bondverbindungsmittels beim Überkreuzen mit dem jeweiligen ersten Bondverbindungsmittel unterhalb des ersten Maximums und/oder des zweiten Maximums verläuft. Der erste Quer-Loop des zweiten Bondverbindungsmittels ist vollständig unterhalb des ersten Maximums und/oder des zweiten Maximums angeordnet, wenn die gesamte Querschnittsfläche des zweiten Bondverbindungsmittels beim Überkreuzen mit dem jeweiligen ersten Bondverbindungsmittel unterhalb des ersten Maximums und/oder des zweiten Maximums verläuft. Das zweite Bondverbindungsmittel verläuft so durch das vom ersten Steppkontakt ausgebildete "Bond-Tal" des jeweiligen ersten Bondverbindungsmittels. Durch einen derartigen Verlauf des zweiten Bondverbindungsmittels über das Halbleiterelement wird eine kürzere Bond-Induktivität erreicht, was sich unter anderem positiv auf die elektrische Performance der Schaltung auswirkt.

Eine weitere Ausführungsform sieht vor, dass das Halbleiterelement auf der dem Substrat abgewandten Seite zumindest eine Steuerkontaktfläche aufweist, wobei das zweite Bondverbindungsmittel mit der Steuerkontaktfläche verbunden ist. Durch einen derartigen Verlauf des zweiten Bondverbindungsmittels über das Halbleiterelement wird vermieden die Verdrahtung für ein Steuersignal um das Halbleiterelement herum verlaufend anzuordnen, sodass eine kürzere Bond-Induktivität erreicht wird, was sich unter anderem positiv auf das Schaltverhalten auswirkt. Ferner wird Bauraum eingespart.

Eine weitere Ausführungsform sieht vor, dass eine Steuerkontaktfläche eines weiteren Halbleiterelements über den ersten Quer-Loop des zweiten Bondverbindungsmittels mit der Steuerkontaktfläche des Halbleiterelements verbunden ist. Durch eine derartige Chip-zu-Chip-Verbindung der Verdrahtung für das Steuersignal wird Bauraum eingespart und eine Bonddrahtlänge reduziert.

Eine weitere Ausführungsform sieht vor, dass das zweite Bondverbindungsmittel in einem Winkel zwischen 75° und 90°, insbesondere zwischen 85° und 90°, zum zumindest einen ersten Bondverbindungsmittel angeordnet ist. Durch eine derartige Anordnung wird eine Verkopplung, unter anderem zwischen Steuersignal und Laststrom, minimiert.

Eine weitere Ausführungsform sieht vor, dass das zumindest eine erste Bondverbindungsmittel auf der Kontaktfläche jeweils einen zweiten Steppkontakt ausbildet, welcher zwischen dem ersten Loop und einem dritten Loop des jeweiligen ersten Bondverbindungsmittels angeordnet ist, wobei der dritte Loop ein drittes Maximum aufweist, wobei ein zweiter Quer-Loop eines dritten Bondverbindungsmittels oberhalb des zweiten Steppkontakts und, parallel zur Kontaktfläche verlaufend betrachtet, zwischen dem ersten Maximum des ersten Loops und dem dritten Maximum des dritten Loops verlaufend angeordnet ist. Durch eine derartige Anordnung wird zusätzlicher Bauraum eingespart.

Eine weitere Ausführungsform sieht vor, dass der erste Quer-Loop des zweiten Bondverbindungsmittels und der zweite Quer-Loop des dritten Bondverbindungsmittels, insbesondere vollständig, unterhalb des ersten Maximums des ersten Loops, des zweiten Maximums des zweiten Loops und/oder des dritten Maximums des dritten Loops verlaufend angeordnet sind. Durch einen derartigen Verlauf des zweiten Bondverbindungsmittels über das Halbleiterelement wird eine kürzere Bond-Induktivität erreicht, was sich unter anderem positiv auf die elektrische Performance der Schaltung auswirkt.

Eine weitere Ausführungsform sieht vor, dass eine Mehrzahl von parallel verlaufend angeordneten ersten Bondverbindungsmitteln auf der Kontaktfläche jeweils zumindest einen ersten Steppkontakt ausbilden, wobei die jeweiligen ersten Steppkontakte zwischen einem ersten Loop und einem zweiten Loop des jeweiligen ersten Bondverbindungsmittels angeordnet sind, wobei der erste Loop des jeweiligen ersten Bondverbindungsmittels ein erstes Maximum und der zweite Loop des jeweiligen ersten Bondverbindungsmittels ein zweites Maximum aufweisen, wobei der erste Quer-Loop des zweiten Bondverbindungsmittels oberhalb der ersten Steppkontakte der parallel verlaufend angeordneten ersten Bondverbindungsmittel und, parallel zur Kontaktfläche verlaufend betrachtet, zwischen dem jeweiligen ersten Maximum des ersten Loops und dem jeweiligen zweiten Maximum des zweiten Loops verlaufend angeordnet ist. Durch die ersten Steppkontakte werden "Bond-Täler" ausgebildet, über welche der Quer-Loop des zweiten Bondverbindungsmittels verläuft. Insbesondere sind die ersten Steppkontakte derartig angeordnet, dass eine Verbindung zwischen den ersten SteppKontakten eine Gerade ausbildet. Die Gerade kann unter anderem parallel zu einer Chipkante verlaufend angeordnet sind. Alternativ können die ersten Steppkontakte versetzt zueinander angeordnet sein. Durch die Verwendung einer Mehrzahl von parallel verlaufend angeordneten ersten Bondverbindungsmitteln, welche jeweils durch "Stitchen" mehrfach mit der Kontaktfläche verbunden sind, wird eine verbesserte Stromverteilung auf einem Halbleiterelement erreicht. Durch einen Verlauf des zweiten Bondverbindungsmittels über den ersten Steppkontakten des Halbleiterelements wird eine kürzere Bond-Induktivität erreicht, was sich unter anderem positiv auf die elektrische Performance der Schaltung auswirkt. Ferner wird Bauraum eingespart.

Eine weitere Ausführungsform sieht vor, dass der erste Quer-Loop des zweiten Bondverbindungsmittels, insbesondere vollständig, unterhalb des jeweiligen ersten Maximums des ersten Loops und/oder des jeweiligen zweiten Maximums des zweiten Loops verlaufend angeordnet ist. Das zweite Bondverbindungsmittel verläuft so durch die von jeweiligen ersten Steppkontakten ausgebildeten "Bond-Täler". Durch einen derartigen Verlauf des zweiten Bondverbindungsmittels wird eine kürzere Bond-Induktivität erreicht, was sich unter anderem positiv auf die elektrische Performance der Schaltung auswirkt.

Im Folgenden wird die Erfindung anhand der in den Figuren dargestellten Ausführungsbeispiele näher beschrieben und erläutert.

Es zeigen:
- FIG 1: eine schematische Darstellung einer ersten Ausführungsform einer Halbleiteranordnung in einer Draufsicht,
- FIG 2: eine schematische Darstellung der ersten Ausführungsform der Halbleiteranordnung in einer Querschnittsdarstellung,
- FIG 3: eine schematische Darstellung einer zweiten Ausführungsform einer Halbleiteranordnung in einer Draufsicht,
- FIG 4: eine schematische Darstellung der zweiten Ausführungsform der Halbleiteranordnung in einer Querschnittsdarstellung,
- FIG 5: eine schematische Darstellung einer dritten Ausführungsform einer Halbleiteranordnung in einer Draufsicht,
- FIG 6: eine schematische Darstellung der dritten Ausführungsform der Halbleiteranordnung in einer Querschnittsdarstellung,
- FIG 7: eine schematische Darstellung einer vierten Ausführungsform einer Halbleiteranordnung in einer Draufsicht,
- FIG 8: eine vergrößerte schematische Darstellung einer fünften Ausführungsform einer Halbleiteranordnung in einer Querschnittsdarstellung,
- FIG 9: eine vergrößerte schematische Darstellung einer sechsten Ausführungsform einer Halbleiteranordnung in einer Querschnittsdarstellung,
- FIG 10: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

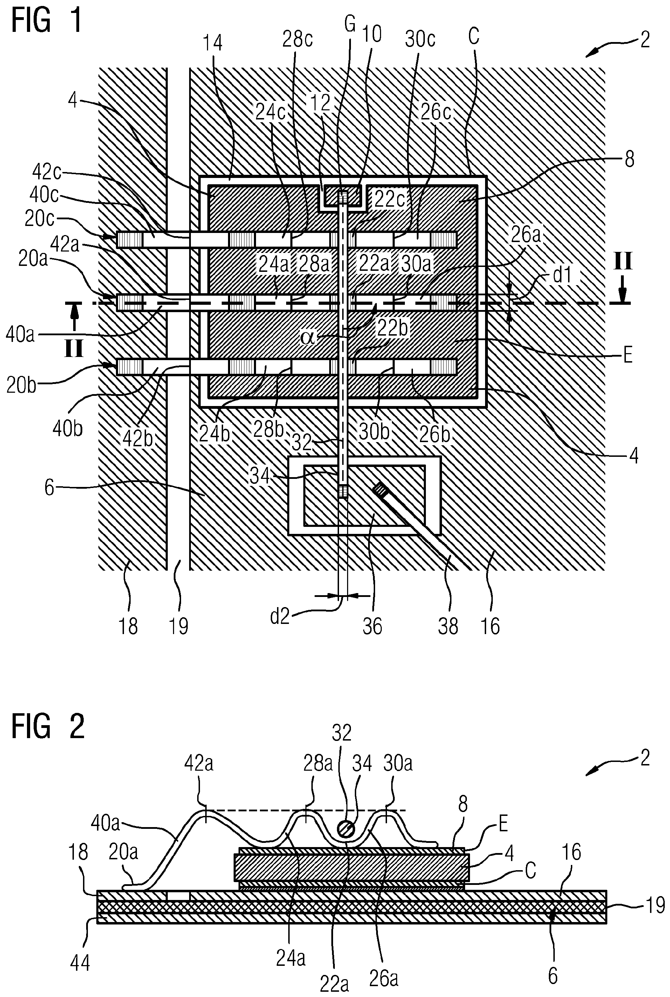

FIG 1 zeigt eine schematische Darstellung einer ersten Ausführungsform einer Halbleiteranordnung 2 in einer Draufsicht, welche ein Halbleiterelement 4 umfasst, das auf einem Substrat 6 kontaktiert ist. Beispielhaft ist das Halbleiterelement 4 als ein Insulated-Gate-Bipolar-Transistor (IGBT) ausgeführt. Weitere Beispiele für derartige Halbleiterelemente 4 sind Triacs, Thyristoren, Dioden oder andere Transistortypen wie Feldeffekttransistoren. Der IGBT umfasst einen Steueranschluss, welcher als Gate-Anschluss G ausgeführt ist, sowie Lastanschlüsse, welche als Kollektor-Anschluss C und Emitter-Anschluss E ausgeführt sind, wobei der Kollektor-Anschluss C, auf einer dem Substrat 6 zugewandten Seite des Halbleiterelements 4 stoffschlüssig, mit dem Substrat 6 verbunden ist. Der Emitter-Anschluss E weist eine Kontaktfläche 8 auf, wobei der Gate-Anschluss G eine Steuerkontaktfläche 10 aufweist. Die Kontaktfläche 8 und die Steuerkontaktfläche 10 weisen zumindest eine metallische Schicht auf, welche beispielsweise Aluminium, Kupfer und/oder Gold enthält. Zwischen der Kontaktfläche 8 des Emitter-Anschlusses E und der Steuerkontaktfläche 10 des Gate-Anschlusses G ist eine elektrisch isolierende Zwischenschicht 12 angeordnet. Ferner weist das Halbleiterelement 4 einen elektrisch isolierenden Schutzring 14 auf. Die elektrisch isolierende Zwischenschicht 12 und der elektrisch isolierenden Schutzring 14 sind aus einem dielektrischen Werkstoff, insbesondere Polyimid oder Aluminiumoxid, hergestellt.

Der IGBT ist, beispielsweise über eine Löt- oder Sinterverbindung, mit einer ersten Leiterbahn 16 des Substrats 6 verbunden. Ferner weist das Substrat 6 eine von der ersten Leiterbahn 16 isoliert angeordnete zweite Leiterbahn 18 auf. Darüber hinaus umfasst das Substrat 6 eine dielektrische Materiallage 19, die beispielsweise einen keramischen Werkstoff, insbesondere Aluminiumnitrid oder Aluminiumoxid, enthält und eine Dicke d von 25 µm bis 400 µm, insbesondere 50 µm bis 250 µm, aufweist. Die zweite Leiterbahn 18 ist über beispielhaft drei erste Bondverbindungsmittel 20a, 20b, 20c mit der Kontaktfläche 8 des Emitter-Anschlusses E verbunden, welche im Wesentlichen parallel verlaufend angeordnet sind. Die ersten Bondverbindungsmittel 20a, 20b, 20c können als Bonddrähte und/oder Bondbänder ausgeführt sein. Insbesondere werden Dickdrahtbonds, beispielsweise aus Aluminium, mit einem im Wesentlichen kreisförmigen Querschnitt mit einem Durchmesser d1 im Bereich von 100 µm bis 500 µm verwendet.

Die Verbindung wird mittels durchgeschleifter Bondverbindungsmittel 20a, 20b, 20c auf der Kontaktfläche 8, insbesondere mittels Multi-Stitch Wedge-to-Wedge-Wirebonding, hergestellt. Durch das mehrfache Bonden, das auch "Stitchen" genannt wird, wird eine verbesserte Stromverteilung auf einem Halbleiterelement 4 erreicht. Die Bondverbindungsmittel 20a, 20b, 20c bilden jeweils einen ersten Steppkontakt 22a, 22b, 22c aus, welche jeweils zwischen einem ersten Loop 24a, 24b, 24c und einem zweiten Loop 26a, 26b, 26c des jeweiligen ersten Bondverbindungsmittels 20a, 20b, 20c angeordnet sind. Eine Verbindung zwischen den ersten Steppkontakten 22a, 22b, 22c bildet eine Gerade aus. Beispielhaft sind die ersten Steppkontakte 22a, 22b, 22c parallel zu einer Chipkante angeordnet. Der erste Loop 24a, 24b, 24c des jeweiligen ersten Bondverbindungsmittels 20a, 20b, 20c weist ein erstes Maximum 28a, 28b, 28c auf, während der zweite Loop 26a, 26b, 26c des jeweiligen ersten Bondverbindungsmittels 20a, 20b, 20c ein zweites Maximum 30a, 30b, 30c aufweist.

Ein erster Quer-Loop 32 eines zweiten Bondverbindungsmittels 34 ist oberhalb der ersten Steppkontakte 22a, 22b, 22c der parallel verlaufend angeordneten ersten Bondverbindungsmittel 20a, 20b, 20c und zwischen dem jeweiligen ersten Maximum 28a, 28b, 28c des ersten Loops 24a, 24b, 24c und dem jeweiligen zweiten Maximum 30a, 30b, 30c des zweiten Loops 26a, 26b, 26c verlaufend angeordnet. Ferner ist der erste Quer-Loop 32 des zweiten Bondverbindungsmittels 34, insbesondere vollständig, unterhalb des jeweiligen ersten Maximums 28a, 28b, 28c des ersten Loops 24a, 24b, 24c und des jeweiligen zweiten Maximums 30a, 30b, 30c des zweiten Loops 26a, 26b, 26c verlaufend angeordnet. Das zweite Bondverbindungsmittel 34 kann unter anderem einen im Wesentlichen kreisförmigen Querschnitt mit deinem Durchmesser d2 aufweisen, welcher kleiner ist als der Durchmesser d1 der ersten Bondverbindungsmittel 20a, 20b, 20c. Ferner wird über das zweite Bondverbindungsmittel 34 eine Verbindung von einer dritten Leiterbahn 36 zum Steueranschluss des IGBTs hergestellt. Darüber hinaus ist das zweite Bondverbindungsmittel 34 in einem im Wesentlichen rechten Winkel α zu den ersten Bondverbindungsmitteln 20a, 20b, 20c angeordnet. Die dritte Leiterbahn 36 ist beispielhaft über ein weiteres Bondverbindungsmittel 38 mit einer Ansteuervorrichtung verbunden, welche aus Gründen der Übersichtlichkeit in FIG 1 nicht dargestellt ist. Alternativ ist die dritte Leiterbahn 36 als ein Anschlusspin eines Gehäuses ausgeführt. Ein derartiger Anschlusspin kann gegenüber dem Substrat 6 erhöht angeordnet sein.

Zwischen der zweiten Leiterbahn 18 und der Kontaktfläche 8 bilden die ersten Bondverbindungsmittel 20a, 20b, 20c jeweils einen dritten Loop 40a, 40b, 40c aus. Der dritte Loop 40a, 40b, 40c des jeweiligen ersten Bondverbindungsmittels 20a, 20b, 20c weist ein drittes Maximum 42a, 42b, 42c auf, wobei der erste Quer-Loop 32 des zweiten Bondverbindungsmittels 34 auch, insbesondere vollständig, unterhalb des jeweiligen dritten Maximums 42a, 42b, 42c des dritten Loops 40a, 40b, 40c verlaufend angeordnet ist.

FIG 2 zeigt eine schematische Darstellung der ersten Ausführungsform der Halbleiteranordnung 2 in einer Querschnittsdarstellung. In der Querschnittsdarstellung ist eine Metallisierung 44 dargestellt.

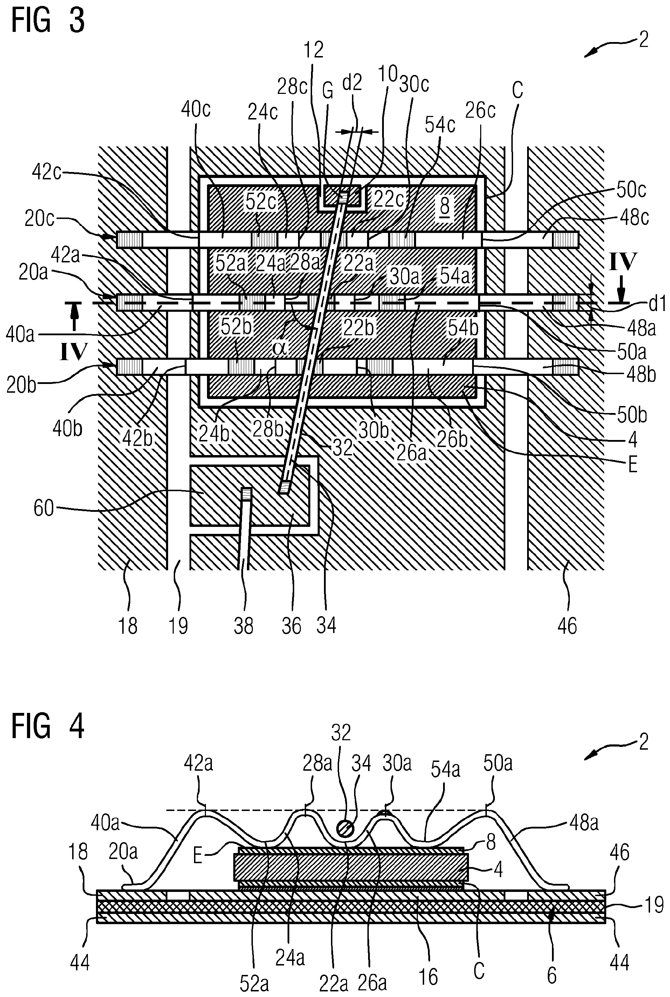

FIG 3 zeigt eine schematische Darstellung einer zweiten Ausführungsform einer Halbleiteranordnung 2 in einer Draufsicht. Die beispielhaft drei im Wesentlichen parallel verlaufend angeordneten ersten Bondverbindungsmittel 20a, 20b, 20c stellen eine Verbindung der Kontaktfläche 8 des Emitter-Anschlusses E zur zweiten Leiterbahn 18 und zu einer vierten Leiterbahn 46, welche von der ersten Leiterbahn 16 und von der zweiten Leiterbahn 18 isoliert angeordnet ist, her. Das Halbleiterelement 4 wird somit "überbondet", das von der zweiten Leiterbahn 18 über den Emitter E mit der vierten Leiterbahn 46 verbunden ist. Zwischen der vierten Leiterbahn 46 und der Kontaktfläche 8 bilden die ersten Bondverbindungsmittel 20a, 20b, 20c jeweils einen vierten Loop 48a, 48b, 48c aus. Der vierte Loop 48a, 48b, 48c des jeweiligen ersten Bondverbindungsmittels 20a, 20b, 20c weist ein viertes Maximum 50a, 50b, 50c auf, wobei der erste Quer-Loop 32 des zweiten Bondverbindungsmittels 34 auch, insbesondere vollständig, unterhalb des jeweiligen vierten Maximums 50a, 50b, 50c des vierten Loops 48a, 48b, 48c verlaufend angeordnet ist.

Darüber hinaus ist das zweite Bondverbindungsmittel 34 in einem Winkel α von weniger als 90°, beispielsweise 80°, zu den ersten Bondverbindungsmitteln 20a, 20b, 20c angeordnet. Damit der erste Quer-Loop 32 zwischen dem jeweiligen ersten Maximum 28a, 28b, 28c des ersten Loops 24a, 24b, 24c und dem jeweiligen zweiten Maximum 30a, 30b, 30c des zweiten Loops 26a, 26b, 26c sowie, insbesondere vollständig, unterhalb des jeweiligen ersten Maximums 28a, 28b, 28c des ersten Loops 24a, 24b, 24c und des jeweiligen zweiten Maximums 30a, 30b, 30c des zweiten Loops 26a, 26b, 26c verlaufend angeordnet ist, sind die ersten Steppkontakte 22a, 22b, 22c versetzt zueinander angeordnet. Die durch die Verbindung des dritten Loops 40a, 40b, 40c und des vierten Loops 48a, 48b, 48c des jeweiligen ersten Bondverbindungsmittels 20a, 20b, 20c zur Kontaktfläche 8 werden zweite Steppkontakte 52a, 52b, 52c und dritte Steppkontakte 54a, 54b, 54c ausgebildet welche, analog zu den ersten Steppkontakten 22a, 22b, 22c versetzt zueinander angeordnet werden, sodass die ersten Loops 24a, 24b, 24c und die zweiten Loops 26a, 26b, 26c jeweils eine im Wesentlichen gleiche Geometrie aufweisen. Die weitere Ausführung der Halbleiteranordnung 2 in FIG 3 entspricht der in FIG 1.

FIG 4 zeigt eine schematische Darstellung der zweiten Ausführungsform der Halbleiteranordnung 2 in einer Querschnittsdarstellung.

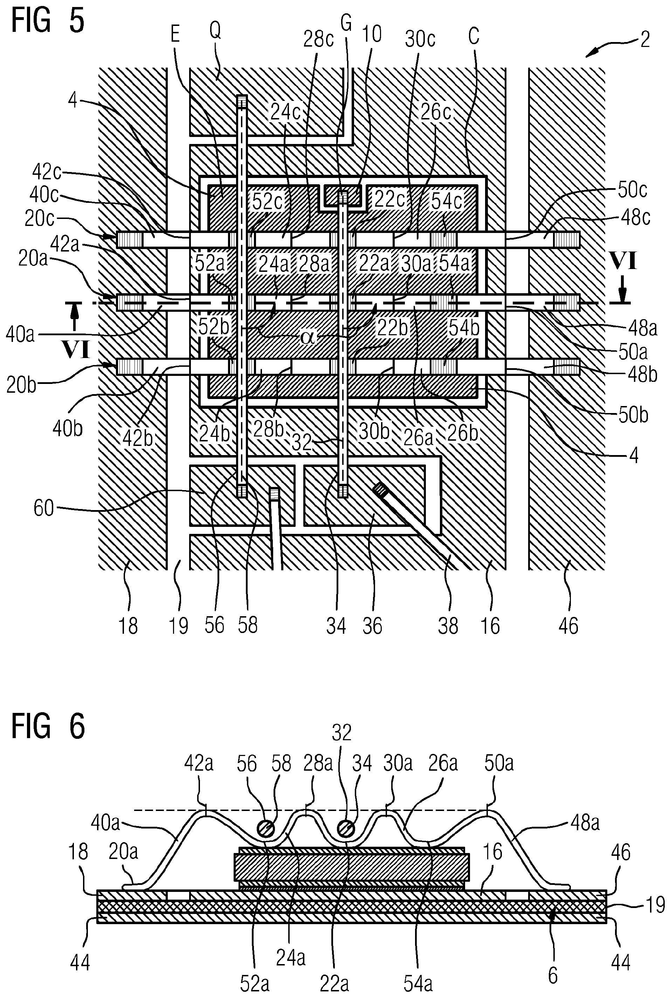

FIG 5 zeigt eine schematische Darstellung einer dritten Ausführungsform einer Halbleiteranordnung in einer Draufsicht, wobei ein zweiter Quer-Loop 56 eines dritten Bondverbindungsmittels 58 oberhalb der zweiten Steppkontakte 52a, 52b, 52c der parallel verlaufend angeordneten ersten Bondverbindungsmittel 20a, 20b, 20c und zwischen dem jeweiligen dritten Maximum 42a, 42b, 42c des dritten Loops 40a, 40b, 40c und dem jeweiligen ersten Maximum 28a, 28b, 28c des ersten Loops 24a, 24b, 24c verlaufend angeordnet ist. Das dritte Bondverbindungsmittel 58 verbindet beispielhaft eine fünfte Leiterbahn 60 mit einer sechsten Leiterbahn 62, wobei das dritte Bondverbindungsmittel 58 das Halbleiterelement 4 über die zweiten Steppkontakte 52a, 52b, 52c vollständig überspannt. Das dritte Bondverbindungsmittel 58 kann als Hilfsemitter-Anschluss ausgeführt sein. Das zweite Bondverbindungsmittel 34 und das dritte Bondverbindungsmittel 58 sind im Wesentlichen parallel zueinander verlaufend angeordnet. Alternativ sind die dritte Leiterbahn 36 und die fünfte Leiterbahn 60 als Anschlusspins eines Gehäuses ausgeführt. Derartige Anschlusspins können gegenüber dem Substrat 6 erhöht angeordnet sein. Die weitere Ausführung der Halbleiteranordnung 2 in FIG 5 entspricht der in FIG 1.

FIG 6 zeigt eine schematische Darstellung der dritten Ausführungsform der Halbleiteranordnung in einer Querschnittsdarstellung.

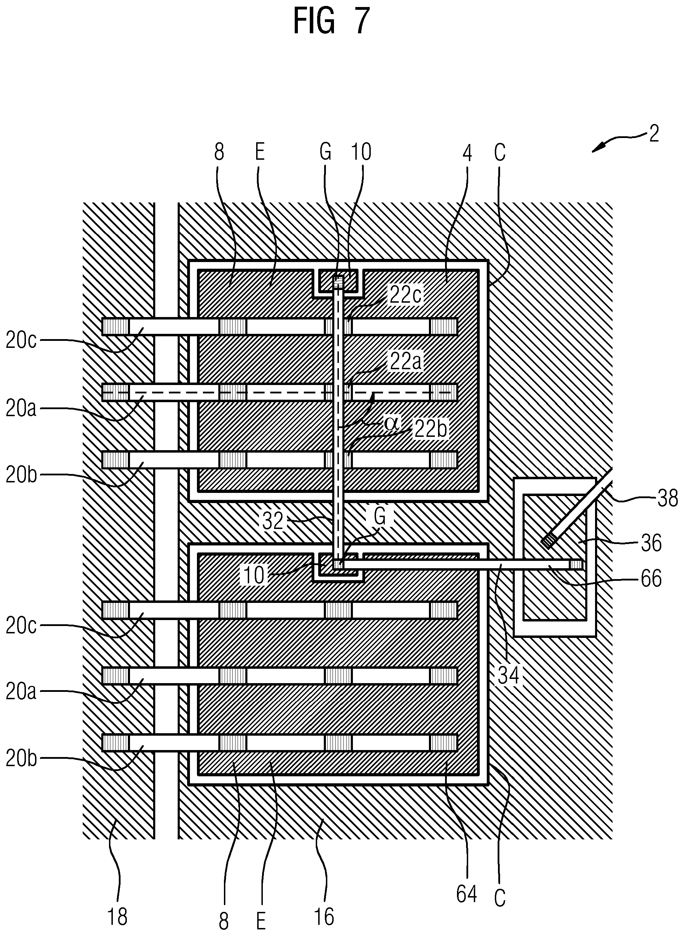

FIG 7 zeigt eine schematische Darstellung einer vierten Ausführungsform einer Halbleiteranordnung in einer Draufsicht, wobei das Halbleiterelement 4 und ein weiteres Halbleiterelement 64 parallelgeschaltet sind. Die Halbleiterelemente 4, 64, welche beispielhaft als IGBTs ausgeführt sind. Die Kontaktflächen 8 der Emitter-Anschlüsse E der parallelgeschalteten Halbleiterelemente 4, 64 sind beispielhaft jeweils über drei erste Bondverbindungsmittel 20a, 20b, 20c mit der zweiten Leiterbahn 18 verbunden, welche im Wesentlichen parallel verlaufend angeordnet sind. Ferner weisen die Halbleiterelemente 4, 64 auf einer dem Substrat 6 abgewandten Seite jeweils eine Steuerkontaktfläche 10 eines Gate-Anschlusses G auf. Der erste Quer-Loop 32 des zweiten Bondverbindungsmittels 34 stellt eine Verbindung der Steuerkontaktfläche 10 des weiteren Halbleiterelements 64 mit der Steuerkontaktfläche 10 des Halbleiterelements 4 her. Ein weiterer Loop 66 des zweiten Bondverbindungsmittels 34 verbindet die Steuerkontaktfläche 10 des weiteren Halbleiterelements 64 mit der dritten Leiterbahn 36, wobei die dritte Leiterbahn 36, wie in FIG 1 gezeigt, beispielhaft über das weitere Bondverbindungsmittel 38 mit einer Ansteuervorrichtung verbunden ist. Das zweite Bondverbindungsmittel 34 verbindet so die Gate-Anschlüsse G der Halbleiterelemente 4, 64 mittels Multi-Stitch Wedge-to-Wedge-Wirebonding mit der dritten Leiterbahn 36. Die weitere Ausführung der Halbleiteranordnung 2 in FIG 7 entspricht der in FIG 1.

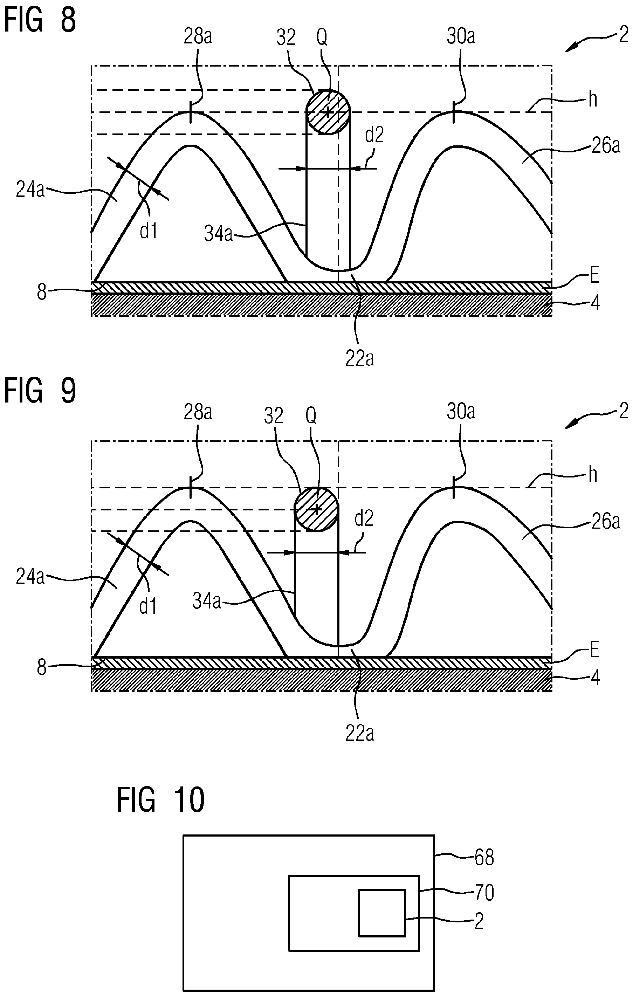

FIG 8 zeigt eine vergrößerte schematische Darstellung einer fünften Ausführungsform einer Halbleiteranordnung 2 in einer Querschnittsdarstellung, wobei ein erster Quer-Loop 32 eines zweiten Bondverbindungsmittels 34 im Bereich eines Halbleiterelements 4 gezeigt ist. Ein erstes Bondverbindungsmittel 20a bildet auf der Kontaktfläche 8 einen ersten Steppkontakt 22a aus, welcher zwischen einem ersten Loop 24a und einem zweiten Loop 26a des ersten Bondverbindungsmittels 20a angeordnet ist. Das zweite Bondverbindungsmittel 34 weist eine im Wesentlichen kreisförmige Querschnittsfläche Q mit einem Durchmesser d2 auf, welcher kleiner als der Durchmesser d1 der Querschnittsfläche des ersten Bondverbindungsmittels 20a ist.

Der erste Loop 24a weist ein erstes Maximum 28a auf, während der zweite Loop 26a ein zweites Maximum 30a aufweist. Beispielhaft weisen das erste Maximum 28a und das zweite Maximum 30a die gleiche Höhe h auf. Unter der Höhe ist beispielsweise ein Abstand der Maxima 28a, 30a vom Substrat 6 zu verstehen. Der erste Quer-Loop 32 des zweiten Bondverbindungsmittels 34 ist oberhalb des ersten Steppkontakts 22a und zwischen dem ersten Maximum 28a des ersten Loops 24a und dem zweiten Maximum 30a des zweiten Loops 26a angeordnet. Ferner ist der erste Quer-Loop 32 des zweiten Bondverbindungsmittels 34 unterhalb des ersten Maximums 28a des ersten Loops 24a und des zweiten Maximums 30a des zweiten Loops 26a verlaufend angeordnet, wobei zumindest ein Teil der Querschnittsfläche Q des zweiten Bondverbindungsmittels 34 beim Überkreuzen mit dem ersten Bondverbindungsmittel 20a unterhalb des ersten Maximums 28a des ersten Loops 24a und des zweiten Maximums 30a des zweiten Loops 26a verläuft. Die weitere Ausführung der Halbleiteranordnung 2 in FIG 8 entspricht der in FIG 1.

FIG 9 zeigt eine vergrößerte schematische Darstellung einer sechsten Ausführungsform einer Halbleiteranordnung 2 in einer Querschnittsdarstellung. Der erste Quer-Loop 32 des zweiten Bondverbindungsmittels 34 ist vollständig unterhalb des ersten Maximums 28a des ersten Loops 24a und des zweiten Maximums 30a des zweiten Loops 26a verlaufend angeordnet, wobei die gesamte Querschnittsfläche Q des zweiten Bondverbindungsmittels 34 beim Überkreuzen mit dem ersten Bondverbindungsmittel 20a unterhalb des ersten Maximums 28a des ersten Loops 24a und des zweiten Maximums 30a des zweiten Loops 26a verläuft. Die weitere Ausführung der Halbleiteranordnung 2 in FIG 9 entspricht der in FIG 8.

FIG 10 zeigt eine schematische Darstellung eines Stromrichters 68, welcher beispielhaft ein Halbleitermodul 70 umfasst. Das Halbleitermodul 70 weist beispielhaft eine Halbleiteranordnung 2 auf.

Zusammenfassend betrifft die Erfindung eine Halbleiteranordnung 2 mit einem Halbleiterelement 4, einem Substrat 6 und Bondverbindungsmitteln 20a, 20b, 20c, 34, 58. Um, im Vergleich zum Stand der Technik, eine verbesserte Verdrahtung zu erreichen, wird vorgeschlagen, dass das Halbleiterelement 4, insbesondere stoffschlüssig, mit dem Substrat 6 verbunden ist, wobei das Halbleiterelement 4 auf einer dem Substrat 6 abgewandten Seite zumindest eine Kontaktfläche 8 aufweist, wobei zumindest eine Kontaktfläche 8 des Halbleiterelements 4 über zumindest ein erstes Bondverbindungsmittel 20a, 20b, 20c mit dem Substrat 6 verbunden ist, wobei das zumindest eine erste Bondverbindungsmittel 20a, 20b, 20c auf der Kontaktfläche 8 zumindest einen ersten Steppkontakt 22a, 22b, 22c ausbildet, welcher zwischen einem ersten Loop 24a, 24b, 24c und einem zweiten Loop 26a, 26b, 26c des zumindest einen ersten Bondverbindungsmittels 20a, 20b, 20c angeordnet ist, wobei der erste Loop 24a, 24b, 24c ein erstes Maximum 28a, 28b, 28c und der zweite Loop 26a, 26b, 26c ein zweites Maximum 30a, 30b, 30c aufweist, wobei ein erster Quer-Loop 32 eines zweiten Bondverbindungsmittels 34 oberhalb des ersten Steppkontakts 22a, 22b, 22c und zwischen dem ersten Maximum 28a, 28b, 28c des ersten Loops 24a, 24b, 24c und dem zweiten Maximum 30a, 30b, 30c des zweiten Loops 26a, 26b, 26c verlaufend angeordnet ist.

## Patentansprüche

1. Halbleiteranordnung (2) mit einem Halbleiterelement (4), einem Substrat (6) und Bondverbindungsmitteln (20a, 20b, 20c, 34, 58),
wobei das Halbleiterelement (4), insbesondere stoffschlüssig, mit dem Substrat (6) verbunden ist,
wobei das Halbleiterelement (4) auf einer dem Substrat (6) abgewandten Seite zumindest eine Kontaktfläche (8) aufweist,
wobei die zumindest eine Kontaktfläche (8) des Halbleiterelements (4) über zumindest ein erstes Bondverbindungsmittel (20a, 20b, 20c) mit dem Substrat (6) verbunden ist,
wobei das zumindest eine erste Bondverbindungsmittel (20a, 20b, 20c) auf der Kontaktfläche (8) jeweils zumindest einen ersten Steppkontakt (22a, 22b, 22c) ausbildet, welcher zwischen einem ersten Loop (24a, 24b, 24c) und einem zweiten Loop (26a, 26b, 26c) des jeweiligen ersten Bondverbindungsmittels (20a, 20b, 20c) angeordnet ist,
wobei der erste Loop (24a, 24b, 24c) ein erstes Maximum (28a, 28b, 28c) und der zweite Loop (26a, 26b, 26c) ein zweites Maximum (30a, 30b, 30c) aufweist,
wobei ein erster Quer-Loop (32) eines zweiten Bondverbindungsmittels (34) oberhalb des ersten Steppkontakts (22a, 22b, 22c) und, parallel zur Kontaktfläche (8) verlaufend betrachtet, zwischen dem ersten Maximum (28a, 28b, 28c) des ersten Loops (24a, 24b, 24c) und dem zweiten Maximum (30a, 30b, 30c) des zweiten Loops (26a, 26b, 26c) verlaufend angeordnet ist,
wobei der erste Quer-Loop (32) des zweiten Bondverbindungsmittels (34), insbesondere vollständig, unterhalb des ersten Maximums (28a, 28b, 28c) des ersten Loops (24a, 24b, 24c) und/oder des zweiten Maximums (30a, 30b, 30c) des zweiten Loops (26a, 26b, 26c) verlaufend angeordnet ist.

2. Halbleiteranordnung (2) nach Anspruch 1,
wobei der erste Quer-Loop (32) des zweiten Bondverbindungsmittels (34) teilweise vom zweiten Loop (26a, 26b, 26c) umschlossen ist.

3. Halbleiteranordnung (2) nach einem der Ansprüche 1 oder 2, wobei das Halbleiterelement (4) auf der dem Substrat (6) abgewandten Seite zumindest eine Steuerkontaktfläche (10) aufweist und
wobei das zweite Bondverbindungsmittel (34) mit der Steuerkontaktfläche (10) verbunden ist.

4. Halbleiteranordnung (2) nach einem der vorherigen Ansprüche,
wobei eine Steuerkontaktfläche (10) eines weiteren Halbleiterelements (64) über den ersten Quer-Loop (32) des zweiten Bondverbindungsmittels (34) mit der Steuerkontaktfläche (10) des Halbleiterelements (4) verbunden ist.

5. Halbleiteranordnung (2) nach einem der vorherigen Ansprüche,
wobei das zweite Bondverbindungsmittel (34) in einem Winkel (α) zwischen 75° und 90°, insbesondere zwischen 85° und 90°, zum zumindest einen ersten Bondverbindungsmittel (20a, 20b, 20c) angeordnet ist.

6. Halbleiteranordnung (2) nach einem der vorherigen Ansprüche,
wobei das zumindest eine erste Bondverbindungsmittel (20a, 20b, 20c) auf der Kontaktfläche (8) jeweils einen zweiten Steppkontakt (52a, 52b, 52c) ausbildet, welcher zwischen dem ersten Loop (24a, 24b, 24c) und einem dritten Loop (40a, 40b, 40c) des jeweiligen ersten Bondverbindungsmittels (20a, 20b, 20c) angeordnet ist,
wobei der dritte Loop (40a, 40b, 40c) ein drittes Maximum (42a, 42b, 42c) aufweist,
wobei ein zweiter Quer-Loop (56) eines dritten Bondverbindungsmittels (58) oberhalb des zweiten Steppkontakts (52a, 52b, 52c) und, parallel zur Kontaktfläche (8) verlaufend betrachtet, zwischen dem ersten Maximum (28a, 28b, 28c) des ersten Loops (24a, 24b, 24c) und dem dritten Maximum (42a, 42b, 42c) des dritten Loops (40a, 40b, 40c) verlaufend angeordnet ist.

7. Halbleiteranordnung (2) nach Anspruch 6,
wobei der erste Quer-Loop (32) des zweiten Bondverbindungsmittels (34) und der zweite Quer-Loop (56) des dritten Bondverbindungsmittels (58), insbesondere vollständig, unterhalb des ersten Maximums (28a, 28b, 28c) des ersten Loops (24a, 24b, 24c), des zweiten Maximums (30a, 30b, 30c) des zweiten Loops (26a, 26b, 26c) und/oder des dritten Maximums (42a, 42b, 42c) des dritten Loops (40a, 40b, 40c) verlaufend angeordnet sind.

8. Halbleiteranordnung (2) nach einem der vorherigen Ansprüche,
wobei eine Mehrzahl von parallel verlaufend angeordneten ersten Bondverbindungsmitteln (20a, 20b, 20c) auf der Kontaktfläche (8) jeweils zumindest einen ersten Steppkontakt (22a, 22b, 22c) ausbilden,
wobei die jeweiligen ersten Steppkontakte (22a, 22b, 22c) zwischen einem ersten Loop (24a, 24b, 24c) und einem zweiten Loop (26a, 26b, 26c) des jeweiligen ersten Bondverbindungsmittels (20a, 20b, 20c) angeordnet sind,
wobei der erste Loop (24a, 24b, 24c) des jeweiligen ersten Bondverbindungsmittels (20a, 20b, 20c) ein erstes Maximum (28a, 28b, 28c) und der zweite Loop (26a, 26b, 26c) des jeweiligen ersten Bondverbindungsmittels (20a, 20b, 20c) ein zweites Maximum (30a, 30b, 30c) aufweisen,
wobei der erste Quer-Loop (32) des zweiten Bondverbindungsmittels (34) oberhalb der ersten Steppkontakte (22a, 22b, 22c) der parallel verlaufend angeordneten ersten Bondverbindungsmittel (20a, 20b, 20c) und, parallel zur Kontaktfläche (8) verlaufend betrachtet, zwischen dem jeweiligen ersten Maximum (28a, 28b, 28c) des ersten Loops (24a, 24b, 24c) und dem jeweiligen zweiten Maximum (30a, 30b, 30c) des zweiten Loops (26a, 26b, 26c) verlaufend angeordnet ist.

9. Halbleiteranordnung (2) nach Anspruch 8,
wobei der erste Quer-Loop (32) des zweiten Bondverbindungsmittels (34), insbesondere vollständig, unterhalb des jeweiligen ersten Maximums (28a, 28b, 28c) des ersten Loops (24a, 24b, 24c) und/oder des jeweiligen zweiten Maximums (30a, 30b, 30c) des zweiten Loops (26a, 26b, 26c) verlaufend angeordnet ist.

10. Halbleitermodul (70) mit mindestens einer Halbleiteranordnung (2) nach einem der vorherigen Ansprüche.

11. Stromrichter (68) mit mindestens einem Halbleitermodul (70) nach dem vorherigen Anspruch.

12. Verfahren zur Herstellung einer Halbleiteranordnung (2) mit einem Halbleiterelement (4), einem Substrat (6) und Bondverbindungsmitteln (20a, 20b, 20c, 34, 58),
wobei das Halbleiterelement (4), insbesondere stoffschlüssig, mit dem Substrat (6) verbunden ist,
wobei das Halbleiterelement (4) auf einer dem Substrat (6) abgewandten Seite zumindest eine Kontaktfläche (8) aufweist, wobei die zumindest eine Kontaktfläche (8) des Halbleiterelements (4) über zumindest ein erstes Bondverbindungsmittel (20a, 20b, 20c) mit dem Substrat (6) verbunden wird, wobei das zumindest eine erste Bondverbindungsmittel (20a, 20b, 20c) auf der Kontaktfläche (8) jeweils zumindest einen ersten Steppkontakt (22a, 22b, 22c) ausbildet, welcher zwischen einem ersten Loop (24a, 24b, 24c) und einem zweiten Loop (26a, 26b, 26c) des jeweiligen ersten Bondverbindungsmittels (20a, 20b, 20c) angeordnet ist,
wobei der erste Loop (24a, 24b, 24c) ein erstes Maximum (28a, 28b, 28c) und der zweite Loop (26a, 26b, 26c) ein zweites Maximum (30a, 30b, 30c) aufweist,
wobei in einem weiteren Schritt ein erster Quer-Loop (32) eines zweiten Bondverbindungsmittels (34) oberhalb des ersten Steppkontakts (22a, 22b, 22c) und, parallel zur Kontaktfläche (8) betrachtet, zwischen dem ersten Maximum (28a, 28b, 28c) des ersten Loops (24a, 24b, 24c) und dem zweiten Maximum (30a, 30b, 30c) des zweiten Loops (26a, 26b, 26c) verlaufend angeordnet wird,
wobei der erste Quer-Loop (32) des zweiten Bondverbindungsmittels (34), insbesondere vollständig, unterhalb des ersten Maximums (28a, 28b, 28c) des ersten Loops (24a, 24b, 24c) und/oder des zweiten Maximums (30a, 30b, 30c) des zweiten Loops (26a, 26b, 26c) verlaufend angeordnet wird.

13. Verfahren nach Anspruch 12,
wobei der erste Quer-Loop (32) des zweiten Bondverbindungsmittels (34) teilweise vom zweiten Loop (26a, 26b, 26c) umschlossen wird.

14. Verfahren nach einem der Ansprüche 12 oder 13,
wobei das zweite Bondverbindungsmittel (34) in einem Winkel (α) von mehr als 75°, insbesondere 85°, zum zumindest einen ersten Bondverbindungsmittel (20a, 20b, 20c) angeordnet wird.

15. Verfahren nach einem der Ansprüche 12 bis 14,
wobei das zumindest eine erste Bondverbindungsmittel (20a, 20b, 20c) auf der Kontaktfläche (8) jeweils einen zweiten Steppkontakt (52a, 52b, 52c) ausbildet, welcher zwischen dem zweiten Loop (26a, 26b, 26c) und einem dritten Loop (40a, 40b, 40c) des jeweiligen zumindest einen ersten Bondverbindungsmittels (20a, 20b, 20c) angeordnet ist,
wobei der dritte Loop (40a, 40b, 40c) ein drittes Maximum (42a, 42b, 42c) aufweist,
wobei in einem weiteren Schritt ein zweiter Quer-Loop (56) eines dritten Bondverbindungsmittels (58) oberhalb des zweiten Steppkontakts (52a, 52b, 52c) und, parallel zur Kontaktfläche (8) verlaufend betrachtet, zwischen dem zweiten Maximum (30a, 30b, 30c) des zweiten Loops (26a, 26b, 26c) und dem dritten Maximum (42a, 42b, 42c) des dritten Loops (40a, 40b, 40c) verlaufend angeordnet wird.

## Claims

1. Semiconductor arrangement (2) with a semiconductor element (4), a substrate (6) and bond connecting means (20a, 20b, 20c, 34, 58),
wherein the semiconductor element (4) is connected, in particular integrally bonded, to the substrate (6),
wherein on a side remote from the substrate (6), the semiconductor element (4) has at least one contact surface (8),
wherein the at least one contact surface (8) of the semiconductor element (4) is connected to the substrate (6) via at least one first bond connecting means (20a, 20b, 20c), wherein on the contact surface (8), the at least one first bond connecting means (20a, 20b, 20c) forms at least one first stitch contact (22a, 22b, 22c) respectively, which is arranged between a first loop (24a, 24b, 24c) and a second loop (26a, 26b, 26c) of the respective first bond connecting means (20a, 20b, 20c),
wherein the first loop (24a, 24b, 24c) has a first maximum (28a, 28b, 28c) and the second loop (26a, 26b, 26c) has a second maximum (30a, 30b, 30c),
wherein a first transverse loop (32) of a second bond connecting means (34) is arranged to run above the first stitch contact (22a, 22b, 22c) and, viewed running parallel to the contact surface (8), between the first maximum (28a, 28b, 28c) of the first loop (24a, 24b, 24c) and the second maximum (30a, 30b, 30c) of the second loop (26a, 26b, 26c), wherein the first transverse loop (32) of the second bond connecting means (34) is arranged to run, in particular completely, below the first maximum (28a, 28b, 28c) of the first loop (24a, 24b, 24c) and/or the second maximum (30a, 30b, 30c) of the second loop (26a, 26b, 26c).

2. Semiconductor arrangement (2) according to claim 1, wherein the first transverse loop (32) of the second bond connecting means (34) is partially enclosed by the second loop (26a, 26b, 26c).

3. Semiconductor arrangement (2) according to one of claims 1 or 2,
wherein on the side remote from the substrate (6), the semiconductor element (4) has at least one control contact surface (10) and
wherein the second bond connecting means (34) is connected to the control contact surface (10).

4. Semiconductor arrangement (2) according to one of the preceding claims,
wherein a control contact surface (10) of a further semiconductor element (64) is connected to the control contact surface (10) of the semiconductor element (4) via the first transverse loop (32) of the second bond connecting means (34).

5. Semiconductor arrangement (2) according to one of the preceding claims,
wherein the second bond connecting means (34) is arranged at an angle (α) between 75° and 90°, in particular between 85° and 90°, to the at least one first bond connecting means (20a, 20b, 20c).

6. Semiconductor arrangement (2) according to one of the preceding claims,
wherein on the contact surface (8), the at least one first bond connecting means (20a, 20b, 20c) forms one second stitch contact (52a, 52b, 52c) respectively, which is arranged between the first loop (24a, 24b, 24c) and a third loop (40a, 40b, 40c) of the respective first bond connecting means (20a, 20b, 20c),
wherein the third loop (40a, 40b, 40c) has a third maximum (42a, 42b, 42c),
wherein a second transverse loop (56) of a third bond connecting means (58) is arranged to run above the second stitch contact (52a, 52b, 52c) and, viewed running parallel to the contact surface (8), between the first
maximum (28a, 28b, 28c) of the first loop (24a, 24b, 24c) and the third maximum (42a, 42b, 42c) of the third loop (40a, 40b, 40c).

7. Semiconductor arrangement (2) according to claim 6, wherein the first transverse loop (32) of the second bond connecting means (34) and the second transverse loop (56) of the third bond connecting means (58) are arranged to run, in particular completely, below the first maximum (28a, 28b, 28c) of the first loop (24a, 24b, 24c), the second
maximum (30a, 30b, 30c) of the second loop (26a, 26b, 26c) and/or the third maximum (42a, 42b, 42c) of the third loop (40a, 40b, 40c).

8. Semiconductor arrangement (2) according to one of the preceding claims,
wherein on the contact surface (8), a plurality of first bond connecting means (20a, 20b, 20c) arranged to run parallel form at least one first stitch contact (22a, 22b, 22c) respectively,
wherein the respective first stitch contacts (22a, 22b, 22c) are arranged between a first loop (24a, 24b, 24c) and a second loop (26a, 26b, 26c) of the respective first bond connecting means (20a, 20b, 20c),
wherein the first loop (24a, 24b, 24c) of the respective first bond connecting means (20a, 20b, 20c) has a first maximum (28a, 28b, 28c) and the second loop (26a, 26b, 26c) of the respective first bond connecting means (20a, 20b, 20c) has a second maximum (30a, 30b, 30c),
wherein the first transverse loop (32) of the second bond connecting means (34) is arranged to run above the first stitch contacts (22a, 22b, 22c) of the first bond connecting means (20a, 20b, 20c) arranged to run parallel and, viewed running parallel to the contact surface (8), between the respective first maximum (28a, 28b, 28c) of the first loop (24a, 24b, 24c) and the respective second maximum (30a, 30b, 30c) of the second loop (26a, 26b, 26c).

9. Semiconductor arrangement (2) according to claim 8, wherein the first transverse loop (32) of the second bond connecting means (34) is arranged to run, in particular completely, below the respective first maximum (28a, 28b, 28c) of the first loop (24a, 24b, 24c) and/or the respective second maximum (30a, 30b, 30c) of the second loop (26a, 26b, 26c).

10. Semiconductor module (70) with at least one semiconductor arrangement (2) according to one of the preceding claims.

11. Power converter (68) with at least one semiconductor module (70) according to the preceding claim.

12. Method for producing a semiconductor arrangement (2) with a semiconductor element (4), a substrate (6) and bond connecting means (20a, 20b, 20c, 34, 58),
wherein the semiconductor element (4) is connected, in particular integrally bonded, to the substrate (6),
wherein on a side remote from the substrate (6), the semiconductor element (4) has at least one contact surface (8),
wherein the at least one contact surface (8) of the semiconductor element (4) is connected to the substrate (6) via at least one first bond connecting means (20a, 20b, 20c), wherein on the contact surface (8), the at least one first bond connecting means (20a, 20b, 20c) forms at least one first stitch contact (22a, 22b, 22c) respectively, which is arranged between a first loop (24a, 24b, 24c) and a second loop (26a, 26b, 26c) of the respective first bond connecting means (20a, 20b, 20c),
wherein the first loop (24a, 24b, 24c) has a first maximum (28a, 28b, 28c) and the second loop (26a, 26b, 26c) has a second maximum (30a, 30b, 30c),
wherein in a further step, a first transverse loop (32) of a second bond connecting means (34) is arranged to run above the first stitch contact (22a, 22b, 22c) and, viewed parallel to the contact surface (8), between the first maximum (28a, 28b, 28c) of the first loop (24a, 24b, 24c) and the second maximum (30a, 30b, 30c) of the second loop (26a, 26b, 26c), wherein the first transverse loop (32) of the second bond connecting means (34) is arranged to run, in particular completely, below the first maximum (28a, 28b, 28c) of the first loop (24a, 24b, 24c) and/or the second maximum (30a, 30b, 30c) of the second loop (26a, 26b, 26c).

13. Method according to claim 12,
wherein the first transverse loop (32) of the second bond connecting means (34) is partially enclosed by the second loop (26a, 26b, 26c).

14. Method according to one of claims 12 or 13,
wherein the second bond connecting means (34) is arranged at an angle (α) of more than 75°, in particular 85°, to the at least one first bond connecting means (20a, 20b, 20c).

15. Method according to one of claims 12 to 14,
wherein on the contact surface (8), the at least one first bond connecting means (20a, 20b, 20c) forms a second stitch contact (52a, 52b, 52c) respectively, which is arranged between the second loop (26a, 26b, 26c) and a third loop (40a, 40b, 40c) of the respective at least one first bond connecting means (20a, 20b, 20c),
wherein the third loop (40a, 40b, 40c) has a third maximum (42a, 42b, 42c),
wherein in a further step, a second transverse loop (56) of a third bond connecting means (58) is arranged to run above the second stitch contact (52a, 52b, 52c) and, viewed running parallel to the contact surface (8), between the second maximum (30a, 30b, 30c) of the second loop (26a, 26b, 26c) and the third maximum (42a, 42b, 42c) of the third loop (40a, 40b, 40c).

## Revendications

1. Dispositif (2) de semiconducteur comprenant un élément (4) semiconducteur, un substrat (6) et des moyens (20a, 20b, 20c, 34, 58) de liaison,
dans lequel l'élément (4) semiconducteur est relié, en particulier à coopération de matière, au substrat (6),
dans lequel l'élément (4) à semiconducteur a au moins une surface (8) de contact sur une face non tournée vers le substrat (6),
dans lequel la au moins une surface (8) de contact de l'élément (4) semiconducteur est connectée au substrat (6) par au moins un premier moyen (20a, 20b, 20c) de liaison, dans lequel le au moins un premier moyen (20a, 20b, 20c) de liaison constitue sur la surface (8) de contact respectivement au moins un premier contact (22a, 22b, 22c) à boucle, qui est disposée entre une première boucle (24a, 24b, 24c) et une deuxième boucle (26a, 26b, 26c) du premier moyen (20a, 20b, 20c) respectif de liaison,
dans lequel la première boucle (24a, 24b, 24c) a un premier maximum (28a, 28b, 28c) et la deuxième boucle (26a, 26b, 26c) un deuxième maximum (30a, 30b, 30c),
dans lequel une première boucle (32) transversale d'un deuxième moyen (34) de liaison est disposée en s'étendant au-dessus du premier contact (22a, 22b, 22c) à boucle et, considéré en s'étendant parallèlement à la surface (8) de contact, entre le premier maximum (28a, 28b, 28c) de la première boucle (24a, 24b, 24c) et le deuxième maximum (30a, 30b, 30c) de la deuxième boucle (26a, 26b, 26c),
dans lequel la première boucle (32) transversale du deuxième moyen (34) de liaison est disposée en s'étendant, en particulier complètement, en dessous du premier maximum (28a, 28b, 28c) de la première boucle (24a, 24b, 24c) et/ou du deuxième maximum (30a, 30b, 30c) de la deuxième boucle (26a, 26b, 26c).

2. Dispositif (2) de semiconducteur suivant la revendication 1,
dans lequel la première boucle (32) transversale du deuxième moyen (34) de liaison est entourée en partie de la deuxième boucle (26a, 26b, 26c).

3. Dispositif (2) de semiconducteur suivant l'une des revendications 1 ou 2,
dans lequel l'élément (4) semiconducteur a au moins une surface (10) de contact de commande sur la face non tournée vers le substrat (6), et
dans lequel le deuxième moyen (34) de liaison est connecté à la surface (10) de contact de commande.

4. Dispositif (2) de semiconducteur suivant l'une des revendications précédentes,
dans lequel une surface (10) de contact de commande d'un autre élément (64) semiconducteur est connectée à la surface (10) de contact de commande de l'élément (4) semiconducteur par la première boucle (32) transversale du deuxième moyen (34) de liaison.

5. Dispositif (2) de semiconducteur suivant l'une des revendications précédentes,
dans lequel le deuxième moyen (34) de liaison fait un angle (α) compris entre 75° et 90°, compris en particulier entre 85° et 90°, avec au moins un premier moyen (20a, 20b, 20c) de liaison.

6. Dispositif (2) de semiconducteur suivant l'une des revendications précédentes,
dans lequel le au moins un premier moyen (20a, 20b, 20c) de liaison constitue sur la surface (8) de contact respectivement un deuxième contact (52a, 52b, 52c) à boucle, qui est disposé entre la première boucle (24a, 24b, 24c) et une troisième boucle (40a, 40b, 40c) du premier moyen (20a, 20b, 20c) respectif de liaison,
dans lequel la troisième boucle (40a, 40b, 40c) a un troisième maximum (42a, 42b, 42c),
dans lequel une deuxième boucle (56) transversale d'un troisième moyen (58) de liaison est disposée en s'étendant au-dessus du deuxième contact (52a, 52b, 52c) à boucle et, considéré en s'étendant parallèlement à la surface (8) de contact, entre le premier maximum (28a, 28b, 28c) de la première boucle (24a, 24b, 24c) et la troisième maximum (42a, 42b, 42c) de la troisième boucle (40a, 40b, 40c).

7. Dispositif (2) de semiconducteur suivant la revendication 6,
dans lequel la première boucle (32) transversale du deuxième moyen (34) de liaison et la deuxième boucle (56) transversale du troisième moyen (58) de liaison sont disposées en s'étendant, en particulier, complètement en dessous du premier maximum (28a, 28b, 28c) de la première boucle (24a, 24b, 24c), du deuxième maximum (30a, 30b, 30c) de la deuxième boucle (26a, 26b, 26c) et/ou du troisième maximum (42a, 42b, 42c) de la troisième boucle (40a, 40b, 40c).

8. Dispositif (2) de semiconducteur suivant l'une des revendications précédentes,
dans lequel une pluralité de premiers moyens (20a, 20b, 20c) de liaison, disposés en s'étendant parallèlement, constituent sur la surface (8) de contact respectivement au moins un premier contact (22a, 22b, 22c) à boucle,
dans lequel les premiers contacts (22a, 22b, 22c) respectifs à boucle sont disposés entre une première boucle (24a, 24b, 24c) et une deuxième boucle (26a, 26b, 26c) du premier moyen (20a, 20b, 20c) respectif de liaison,
dans lequel la première boucle (24a, 24b, 24c) du premier moyen (20a, 20b, 20c) respectif de liaison a un premier maximum (28a, 28b, 28c) et la deuxième boucle (26a, 26b, 26c) du premier moyen (20a, 20b, 20c) respectif de liaison a un deuxième maximum (30a, 30b, 30c),
dans lequel la première boucle (32) transversale du deuxième moyen (34) de liaison est disposée en s'étendant au-dessus du premier contact (22a, 22b, 22c) à boucle du premier moyen (20a, 20b, 20c) de liaison disposé en s'étendant parallèlement et, considéré en s'étendant parallèlement à la surface (8) de contact, entre le premier maximum (28a, 28b, 28c) respectif de la première boucle (24a, 24b, 24c) et le deuxième maximum (30a, 30b, 30c) respectif de la deuxième boucle (26a, 26b, 26c).

9. Dispositif (2) de semiconducteur suivant la revendication 8,
dans lequel la première boucle (32) transversale du deuxième moyen (34) de liaison est disposée en s'étendant, en particulier complètement, en dessous du premier maximum (28a, 28b, 28c) respectif de la première boucle (24a, 24b, 24c) et/ou du deuxième maximum (30a, 30b, 30c) respectif de la deuxième boucle (26a, 26b, 26c).

10. Module (70) à semiconducteur comprenant au moins un agencement (2) de semiconducteur suivant l'une des revendications précédentes.

11. Convertisseur (68) comprenant au moins un module (70) à semiconducteur suivant la revendication précédente.

12. Procédé de production d'un agencement (2) de semiconducteur, comprenant un élément (4) semiconducteur, un substrat (6) et des moyens (20a, 20b, 20c, 34, 58) de liaison,
dans lequel l'élément (4) semiconducteur est relié, en particulier à coopération de matière, au substrat (6),
dans lequel l'élément (4) à semiconducteur a au moins une surface (8) de contact sur une face non tournée vers le substrat (6), dans lequel la au moins une surface (8) de contact de l'élément (4) semiconducteur est connectée au substrat (6) par au moins un premier moyen (20a, 20b, 20c) de liaison, dans lequel le au moins un premier moyen (20a, 20b, 20c) de liaison constitue sur la surface (8) de contact respectivement au moins un premier contact (22a, 22b, 22c) à boucle, qui est disposé entre une première boucle (24a, 24b, 24c) et une deuxième boucle (26a, 26b, 26c) du premier moyen (20a, 20b, 20c) respectif de liaison,
dans lequel la première boucle (24a, 24b, 24c) a un premier maximum (28a, 28b, 28c) et la deuxième boucle (26a, 26b, 26c) un deuxième maximum (30a, 30b, 30c),
dans lequel dans un autre stade, on dispose d'une première boucle (32) transversale d'un deuxième moyen (34) de liaison, de manière à ce qu'elle s'étende au-dessus du premier contact (22a, 22b, 22c) à boucle et, considéré parallèlement à la surface (8) de contact, entre le premier maximum (28a, 28b, 28c) de la première boucle (24a, 24b, 24c) et le deuxième maximum (30a, 30b, 30c) de la deuxième boucle (26a, 26b, 26c),
dans lequel on dispose la première boucle (32) transversale du deuxième moyen (34) de liaison, de manière à ce qu'elle s'étende, en particulier complètement, en dessous du premier maximum (28a, 28b, 28c) de la première boucle (24a, 24b, 24c) et/ou du deuxième maximum (30a, 30b, 30c) de la deuxième boucle (26a, 26b, 26c).

13. Procédé suivant la revendication 12,
dans lequel on entoure la première boucle (32) transversale du deuxième moyen (34) de liaison en partie de la deuxième boucle (26a, 26b, 26c).

14. Procédé suivant l'une des revendications 12 ou 13,
dans lequel on dispose le deuxième moyen (34) de liaison suivant un angle (α) de plus de 75°, en particulier de 85°, par rapport à au moins un premier moyen (20a, 20b, 20c) de liaison.

15. Procédé suivant l'une des revendications 12 à 14,
dans lequel le au moins un premier moyen (20a, 20b, 20c) de liaison constitue sur la surface (8) de contact respectivement un deuxième contact (52a, 52b, 52c) à boucle, qui est disposé entre la deuxième boucle (26a, 26b, 26c) et une troisième boucle (40a, 40b, 40c) du au moins un premier moyen (20a, 20b, 20c) respectif de liaison, dans lequel la troisième boucle (40a, 40b, 40c) a un troisième maximum (42a, 42b, 42c),
dans lequel on dispose, dans un autre stade, une deuxième boucle (56) transversale d'un troisième moyen (58) de liaison, de manière à ce qu'elle s'étende au-dessus du deuxième contact (52a, 52b, 52c) à boucle et, considéré en s'étendant parallèlement à la surface (8) de contact, entre le deuxième maximum (30a, 30b, 30c) de la deuxième boucle (26a, 26b, 26c) et le troisième maximum (42a, 42b, 42c) de la troisième boucle (40a, 40b, 40c).
